(19) Europäisches Patentamt
European Patent Office
Office européen des brevets

(11) Publication number : **0 487 261 A1**

(12) **EUROPEAN PATENT APPLICATION**

(21) Application number : **91310559.9**

(51) Int. Cl.$^5$ : **G03F 7/039**

(22) Date of filing : **15.11.91**

(30) Priority : **19.11.90 JP 313205/90**

(43) Date of publication of application : **27.05.92 Bulletin 92/22**

(84) Designated Contracting States : **DE FR GB**

(71) Applicant : **FUJITSU LIMITED**
**1015, Kamikodanaka Nakahara-ku**
**Kawasaki-shi Kanagawa 211 (JP)**

(72) Inventor : **Kaimoto, Yuko, c/o Fujitsu Limited**
**1015 Kamikodanaka, Nakahara-ku**
**Kawasaki-shi, Kanagawa 211 (JP)**
Inventor : **Nozaki, Koji, c/o Fujitsu Limited**
**1015 Kamikodanaka, Nakahara-ku**
**Kawasaki-shi, Kanagawa 211 (JP)**

(74) Representative : **Perry, Robert Edward**
**GILL JENNINGS & EVERY 53-64 Chancery Lane**
**London WC2A 1HN (GB)**

(54) **Process for forming resist pattern and resist composition therefor.**

(57) A process for forming a resist pattern and a resist composition therefor are disclosed. This process comprises steps of :

coating a substrate to be fabricated with a resist composition comprising a poly(tetrahydropyranylmethacrylate)(1) :

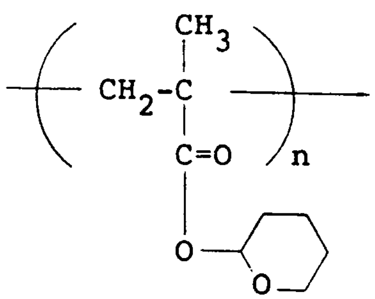

... (1)

wherein, n is 50 to 5300 and a photo acid generator,

exposing the resist film selectively and

baking the resist film,, followed by developing the pattern-wise exposed resist film with a developer to form a resist pattern.

Whereby a finely-resolved resist pattern with a high sensitivity is obtained by a present process for forming the resist pattern.

EP 0 487 261 A1

## BACKGROUND OF THE INVENTION

### 1. Field of the Invention

The present invention relates to a process for forming a resist pattern and a resist composition therefor.

More particularly, the present invention relates to forming a finely-resolved resist pattern and a resist composition including poly(methacryl acid) derivatives and a photo acid generator.

### 2. Description of the Related Art

Due to the necessity for treating a large amount of information at a high speed on an integrated semiconductor device, which plays a main role in an information treating device, large-scale integrated circuits (LSI) and very large-scale integrated circuits (VLSI) have been developed and are now in practice.

This integration is carried out by miniaturization of unit elements such as wiring patterns and electrodes. At present, the use of minimum line spacing of the wiring pattern on a order of submicrons is common.

When manufacturing a semiconductor integrated circuit, a resist is coated on the semiconductor substrate, and then selectively exposed and developed to dissolve the exposed areas or unexposed areas, and finally a through hole is formed. Thereafter, a photo-etching technique (photolithography or electron-beam lithography) is conducted, whereby a conductive film or an insulating film is etched by an etching process. When forming a fine resist pattern, ultraviolet rays were employed at the beginning of the field of photolisography. Due to limitations in the use of the wavelength, the light now used is that having a shortwave length, and exposure using a far ultraviolet light is carried out.

Here, the light source that radiates a far ultraviolet light as mentioned can be a high pressure mercury lamp or an excimer laser.

However, there is the problem that the power of the high pressure mercury lamp will decrease when the light to be used moves to the far ultraviolet light.

Therefore, the use of a large power excimer laser (for instance, when KrF gas is used, wavelength is 248 nm) has been considered as the exposure light source.

However, even if the excimer laser beam is employed, the prior resist composition cannot be used, because said resist absorbs too much far ultraviolet lights, so that the resolution of the pattern obtained is poor.

Therefore, practical use of such a resist composition having a high sensitivity and a high resolution and capable of being applied to the above wavelength light is desired.

Incidentally, instead of the prior resist composition, in which novolac resin was used as a base material, a process realizing a high sensitivity and a high resolution for a resist has been proposed by IBM. In the process a photo acid generator (in short PAG), which generates an acid by means of light exposure, is used (Japanese Patent Application No. 2-27660).

In this process, a polymer is mixed with a photo acid generator, then the mixture is spun onto a substrate, and the resultant film is exposed to the light. Exposure converts some of the PAG to acid. This acid catalyzes the cleavage at an acid sensitive ester group of the polymer during the post exposure bake. This type of resist is known as a chemical amplification resist.

Here, the photo acid generators are, for example, diaryliodonium

salts such as 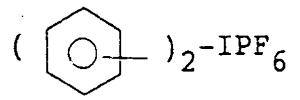 , 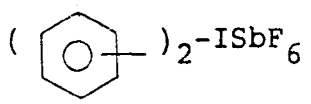 , and 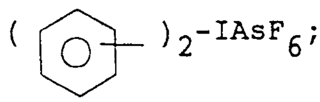 ; and arylsulfonium salts such as 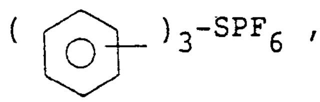 , 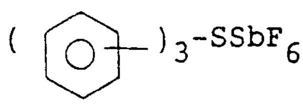 , 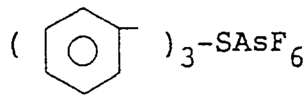 , and 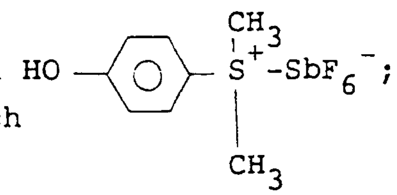 ; sulfonic acid ester derivatives such as 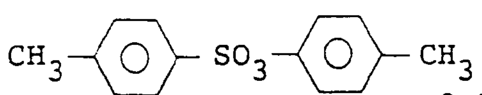 and 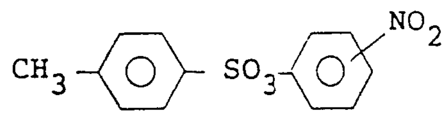

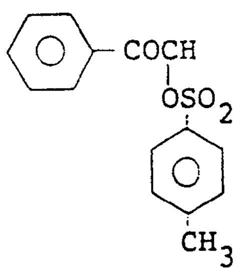 and 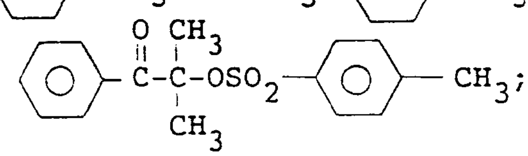 ; and

halogen-containing compounds such as

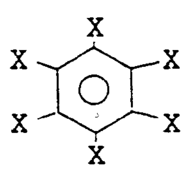 (X is Br or Cl) and 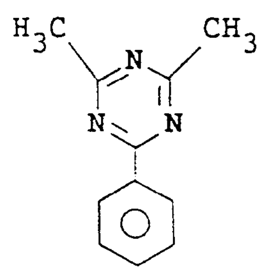

The exposed areas, where acid labile groups have been cleared, form polar carboxylic acid units. When a negative-working pattern is expected to be obtained, a nonpolar organic solvent is used as a developer to dissolve the nonpolar, uneposed regions, and when a positive-working pattern is expected to be obtained, an alkaline developer or polar organic solvents are used to dissolve the polar exposed portions.

The chemical amplification resist proposed by IBM is a polymer having a group of carboxylic acid tert-butyl ester or phenol tert-butyl carbonate, which is also a base polymer.

For instance, the above mentioned resist comprises poly(tert-butylmethacrylate)(3):

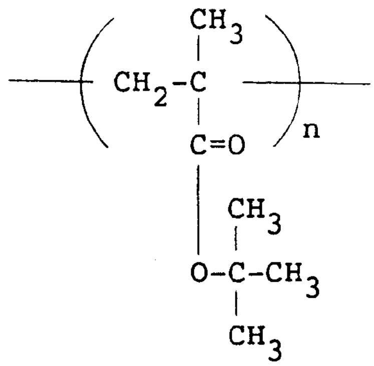

... (3)

(Japanese Patent Application No. 2-27660).

The characteristics of this resist are as follows. As the exposed region, the oxygen atom of the carbonylgroup is protonated by the acid from the decomposed PAG. And then a tert-butyl group cleaves to produce poly(methacrylic acid), isobutene, and proton. This regenerated proton cleaves another ester group. This reaction recurs as shown in Fig. 4. The generated isobutene can easily vaporise by post expose baking. This type of resist can provide a positive-working pattern by an alkaline developer or a polar organic solvent.

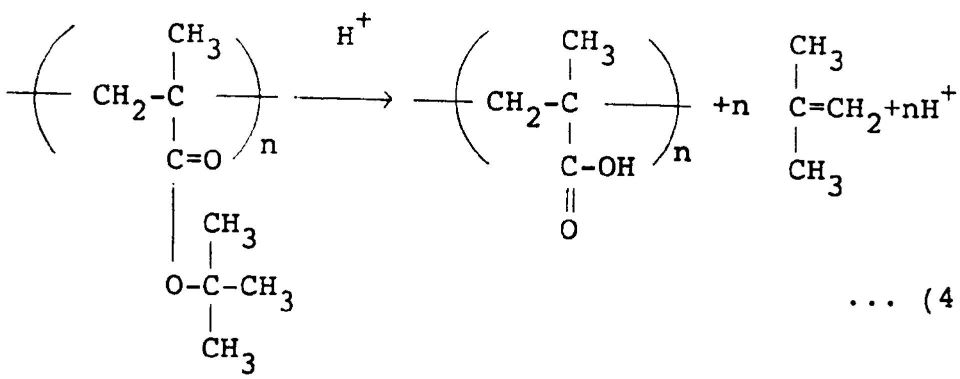

... (4)

However, the present inventors found that the sensitivity of the above-mentioned resist is less than 80 mJ/cm$^2$ by carrying out the experiments. This sensitivity is not as superior as usually expected.

Therefore, there is a need to develop a new photoresist having a further superior sensitivity.

SUMMARY OF THE INVENTION

A primary object of the present invention is provide a process for forming a resist pattern, which comprises the steps of:

coating a substrate to be fabricated with a resist composition comprising a poly(tetrahydropyranylmethacrylate)(1).

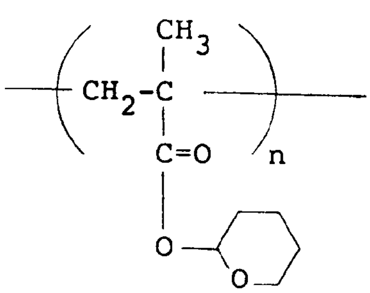

... (1)

wherein, n is 50 to 5300 and a photo acid generator,

baking the resist composition to form a resist film, exposing the resist coating selectively to a predetermined pattern of radiation to form a latent image in the resist layer corresponding to the radiation pattern, and

baking the resist coating, followed by developing the pattern-wise exposed resist film with a developer to form a resist pattern.

It is another object of the present invention to provide a resist composition which comprises:

a poly(tetrahydropyranylmethacrylate)(1).

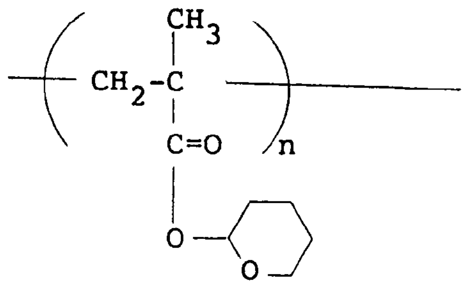

... (1)

wherein n is 50 to 5300, and

a photo acid generator.

DESCRIPTION OF THE PREFERRED EMBODIMENTS

The above-mentioned problems can be solved by the present process for forming a resist pattern and a resist composition.

The present inventors carried out experiments with the hope of finding a new polymer having a greater sensitivity than that of the poly(tert-butylmethacrylate) and the polymer is an ester that generates a poly(methacrylic acid) by a catalytic action of the brusted acid ($H^+$) just as the poly(tert-butylmethacrylate).

As a result of the experiments, the present inventors discovered the new poly(tetrahydropyranylmethacrylate), as a base polymer for the chemical amplification resist.

As is shown in the Fig. (2);

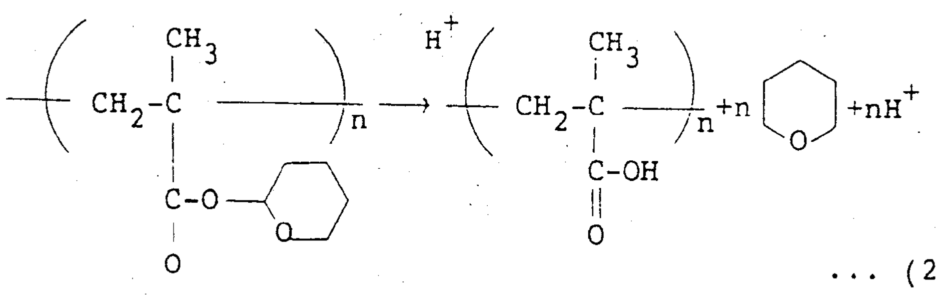

... (2)

the acid labile pendant group is smoothly deprotected to poly(methacrylic acid), and dihydropyrane with the photo-generated acid, and the formed dihydropyran can easily be vaporized.

This catalytic reaction proceeds in sequence just as the tert-butyl ester.

Also, the present resist comprising a poly(methacrylic acid ester) is characterized in that the base polymer has no aromatic rings so that the spin-coated film on a substrate has a higher transparency at a wavelength of 248 nm than that of the novolac-type resist, and therefore, can provide a superior resolution.

In the present invention, the preferred photo acid generators are, for example, triphenylsulphonium hexafluoroantimonate

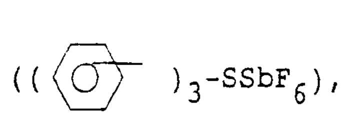

dimethyl-4-hydroxyphenylsulphonium hexafluoroantimonate

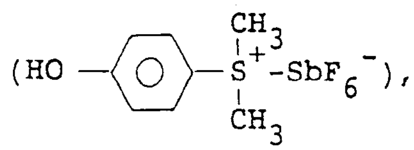

2-methyl-2-p-toluenesulfonyloxypropiophenone and benzointosylate

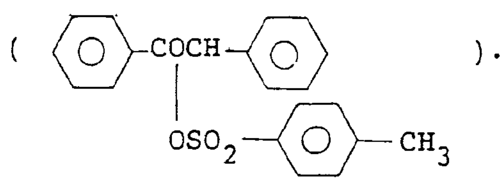

The ratio of the photo acid generator to the base polymer in the present invention is not limited, however, in general, about 1% by weight to about 20% by weight of the photo acid generator is preferable.

The process of the present invention is valuable for the formation of either a positive-working resist pattern or a negative-working resist pattern. As described hereinbefore, when the negative-working pattern is expected to be obtained, a nonpolar organic solvent is used as a developer, and when the positive-working pattern is expected to be obtained, an alkaline aqueous solution or a polar organic solvent is used as a developer. Moreover, the resist material to be used in the present invention can have a sensitivity to light from various light sources, and in the instant specification, the word "light" or "radiation" is used in a broad sense, and a variety of light sources ranging from high-energy radiation light such as electron beams and ion beams to X-rays and ultraviolet rays can be used.

In the present invention, the preferred light source is a excimer laser.

Also, in the present invention, a baking process is effected at room temperature or under heating to vaporize the solvent in the resist composition film.

Also, in the present invention, a baking process is preferably carried out from 60°C to 120°C to accelerate the reaction of poly(tetrahydropyranylmethacrylate) with a photo acid generator expressed by Fig. (2).

If the temperature is less than 60°C, the sensitivity of the obtained resist pattern is low. On the other hand, if the temperature is over 120°C, the above reaction of the Fig. (2) proceeds too fast.

And the pattrn profiles are not good.

The invention will be more clearly understood with reference to the following examples. It is to be expressly understood, however, that there are examples for the purpose of illustration, but they are not intended as a definition of the limits of the invention.

Example

Synthetic Example 1

A preparation of tetrahydropyranylmethacrylate

To a stirred solution of 20% of methacrylic acid and 23.45g of dihidropyran in 120ml of methylene chloride, there was added 29mg of pyridinium p-toluenesulfonate. The mixture was stirred for 3 hour at ambient temperature. The reaction mixture was washed with 80ml of dil. $KHCO_3$ aq. and the organic layer was separated. The water layer was extracted by ether for three times, then the extract was combined the separated organic layer. Followed by brine washing, the organic layer was dried over anhydrous $Na_2SO_4$, filtered, concentrated under reduced pressure, and the residual liquid was distilled to give 24.91g (63%) of tetrahydropyranylmethacrylate as a clear oil, b.p. 61.5-61.9° (0.65mmHg).

Synthetic Example 2

A preparation of poly(tetrahydropyranylmethacrylate)

A stirred solution of 10g of tetrahydropyranylmethacrylate and 193mg of AIBN in 11.8ml of toluene was heated to 75° under nitrogen for 5 hours to obtain viscous liquid. The mixture was diluted with toluene to 50ml, and the polymer was precipitated in 51 of methanol. The white powder was filtered off with a grass filter, and

then dried for 5 hours at 0.5mmHg at 40°. The dried polymer was dissolved in 50ml of THF, and reprecipitated in 51 of methanol. The white powder was filtered off with a grass filter, then dried for 20 hours at 0.5mmHg at 40°, to provide 7.8g(78%) of poly(tetrahydropyranlmethacrylate) as white powder. The polymer has weight-average molecular weight(Mw) of 31,000 and Mw/Mn=1.73.(GPC)

Example 1

Poly(tetrahydropyranylmethacrylate)(weight-average molecular weight 31,100) was dissolved in cyclohexanone at 18 w/w % of solid. Triphenylsulfonium hexafluoroantimonate (supplied by Midori Corp.) was added as a photo acid generator at a loading of 5 w/w % to the polymer. The resist film was spin-coated from the filtered solution onto the hexamethyldisilazane(HMDS) pre-treated silicon oxide wafer at 2000 rpm to give a 1 μm thick layer. The film was baked at 100°C for 20 minutes, and then exposed by a KrF excimer laser stepper(Na=0.37). The exposed film was post-exposure-baked at 100°C for 30 seconds. 0.35 μm line and space patterns with nearly vertical wall angles were obtained by development in aqueous solution of 2.38% tetramethylammonium hydrooxide(TMAH), and the sensitivity was 30 mJ/cm$^2$. The transparency of the obtained resist at a wavelength of 248 nm was 70%.

Example 2

Poly(tetrahydropyranylmethacrylate)(weight-average molecular weight 31,100) was dissolved in cyclohexanone at 18 w/w % of solid. 4-hydroxyphenyldimethysulfonium hexafluoroantimonate (prepared according to the method described in J. Polym. Sci. Chem. Ed., 18, 1021(1980)) was added as a photo acid generator at a loading of 5 w/w % to the polymer. The solution was filtered and spun on to the HMDS pre-treated silicon oxide wafer at 2000 rpm to give a 1 μm thick layer. The film was baked at 100°C for 20 minutes, and then exposed by a KrF excimer laser stepper(Na=0.37). The exposed film was post-exposure-baked at 100°C for 30 seconds. 0.35 μm line and space patterns with nearly vertical wall angles were obtained by development in 2.38% TMAH aq., and the sensitivity was 10 mJ/cm$^2$. The transparency of the obtained resist at a wavelength of 248 nm was 78%.

Example 3

Poly(tetrahydropyranylmethacrylate)(weight-average molecular weight 31,100) was dissolved in cyclohexnone at 18 w/w % of solid. 2-methyl-2-p-toluenesulfony loxypropiophenone($PhC(O)C(CH_2)OTos$) (prepared according to the method described in EP 84515(1982)) was added as a photo acid generator at a loading of 5 w/w % to the polymer. From the filtered solution, the resist film was spun on to the HMDS pre-treated silicon oxide wafer at 2000 rpm to give a 1 μm thick layer. The film was baked at 100°C for 20 minutes, and then exposed by a KrF excimer laser stepper(Na=0.37). The post exposure bake was employed to the exposed film at 100°C for 30 seconds. 0.35 μm line and space patterns with nearly vertical wall angles were obtained by development in 2.38% TMAH aq., and the sensitivity was 1 mJ/cm$^2$. The transparency of the obtained resist at a wavelength of 248 nm was 72%.

Example 4

Poly(tetrahydropyranylmethacrylate)(weight-average molecular weight 31,100) was dissolved in cyclohexanone at 20 w/w % of solid. Benzointosylate(supplied by Midori Corp.) was added as a photo acid generator at a loading of 10 w/w % to the polymer. The resist film was spin-coated from the filtered solution onto the HMDS pre-treated silicon oxide wafer at 2700 rpm to give a 1 μm thick layer. The film was baked at 100°C for 20 minutes, and then exposed by a KrF excimer laser stepper(Na=0.37). The post exposure bake was employed to the exposed film at 100°C for 30 seconds. 0.40 μm line and space patterns with nearly vertical wall angles were obtained by development in 2.38% TMAH aq., and the sensitivity was 0.3 mJ/cm$^2$.

Example 5

Poly(tetrahydropyranylmethacrylate)(weight-average molecular weight 31,100) was dissolved in cyclohexanone at 20 w/w % of solid. Benzointosylate(supplied by Midori Corpolation) was added as a photo acid generator at a loading of 1 w/w % to the polymer. The solution was filtered and spun on to the HMDS pre-treated silicon oxide wafer at 2200 rpm to give a 1 μm thick layer. The film was baked at 100°C for 20 minutes, and then exposed by a KrF excimer laser stepper(Na=0.37). The exposed film was post-exposure-baked at 100°C

for 30 seconds. 0.35 μm line and space patterns with nearly vertical wall angles were obtained by development in 2.38% TMAH aq., and the sensitivity was 10 $mJ/cm^2$. The transparency of the obtained resist at a wavelength of 248 nm was 72%. This data show that the present resist composition can provide a resist pattern having a high sensitivity, regardless at the amount of photo acid generator used.

## Claims

1. A process for forming a resist pattern, which comprises steps of:
coating a substrate to be fabricated with a resist composition comprising a poly(tetrahydropyranylmethacrylate)(1):

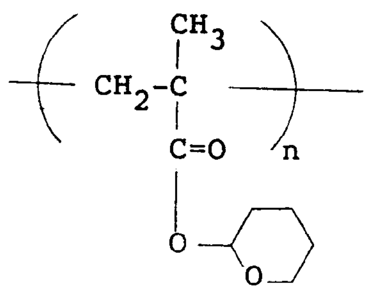

... (1)

wherein, n is 50 to 5300 and a photo acid generator,
exposing the resist film selectively and
baking the resist film, followed by developing the pattern-wise exposed resist film with a developer to form a resist pattern.

2. A process according to claim 1, wherein an exposure light source is an electron beam, excimer laser or X-ray.

3. A process according to claim 1, wherein the photo acid generator is a diaryl iodonium salt or a triarylsulfonium salt.

4. A process forming negative patterns according to claim 1, the developer is a nonpolar organic solvent.

5. A process forming positive patterns according to claim 1, the developer is an alkaline aqueous solution or a polar organic solvent.

6. A process according to claim 1, the baking is carried out from about 60°C to about 120°C.

7. A resist composition, which comprises:
a poly(tetrahydropyranylmethacrylate)(1).

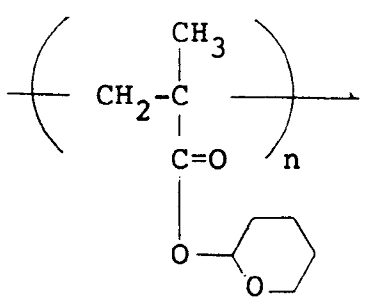

... (1)

wherein, n is 50 to 5300, and
a photo acid generator.

8. A resist composition according to claim 7, wherein the photo acid generator is a compound selected from the group of diaryl iodonium salt, triarylsulfonium salt, sulfonic acid ester and benzointosylate.

European Patent Office

# EUROPEAN SEARCH REPORT

Application Number

EP 91 31 0559

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X<br>Y | WORLD PATENTS INDEX LATEST<br>Week 9047,<br>Derwent Publications Ltd., London, GB;<br>AN 90-351033<br>& JP-2 248 952 (TOSHIBA KK) 4 October 1990<br>* abstract *<br>--- | 1-3,5-8<br>4 | G03F7/039 |
| Y | IBM TECHNICAL DISCLOSURE BULLETIN.<br>vol. 27, no. 1A, June 1984, NEW YORK US<br>page 162;<br>CLECAK N.J., ITO H., WILLSON C.G.: 'UV hardening of resist images'<br>* the whole document *<br>--- | 4 | |
| P,Y | EP-A-0 404 206 (INTERNATIONAL BUSINESS MACHINES CORPORATION)<br>* claims *<br>--- | 4 | |
| A | JOURNAL OF IMAGING TECHNOLOGY.<br>vol. 11, no. 4, August 1985, SPRINGFIELD US<br>pages 146 - 157;<br>PAPPAS S. P.: 'Photogeneration of acid : part 6 - A review of basic principles for resist imaging applications'<br>* the whole document *<br>----- | 1 | TECHNICAL FIELDS SEARCHED (Int. Cl.5 )<br>G03F |

The present search report has been drawn up for all claims

| Place of search | Date of completion of the search | Examiner |
|---|---|---|
| THE HAGUE | 12 FEBRUARY 1992 | LUDI M.M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)